# FASCICULE DE BREVET EUROPEEN

(11) **EP 0 681 197 B1**
(45) Date de publication et mention de la délivrance du brevet: **17.04.2002**
(21) Numéro de dépôt: 95401007.0
(22) Date de dépôt: 02.05.1995
(51) Int. Cl.: G02B 6/30, G02B 6/12, H01L 27/15, H01L 31/00

(54) **Dispositif semi-conducteur optoélectronique comportant un adaptateur de mode intégré**
Optoelektronische Halbleitervorrichtung mit einem integrierten Modenanpassungselement
Opto-electronic semiconductor device with an integrated mode adapter

(30) Priorité: 02.05.1994 FR 9405304
(43) Date de publication de la demande: 08.11.1995
(73) Titulaire: ALCATEL, 75382 Paris Cédex 08 (FR)
(72) Inventeur: Ghirardi, Frédéric, F-75012 Paris (FR); Mersali, Boumédienne, F-94110 Arcueil (FR); Bruno, Adrien, F-91120 Palaiseau (FR); Giroudet, Louis, F-93500 Pantin (FR)
(74) Mandataire: Lamoureux, Bernard

(56) Documents cités:
- ELECTRONICS LETTERS., vol.29, no.4, 18 Décembre 1993, ENAGE GB pages 326 - 328 TH.SCHWANDER ET.AL. 'Simple and low-loss fibre-to-chip coupling by integrated field-matching waveguide in InP'
- IEEE PHOTONICS TECHNOLOGY LETTERS, vol.5, no.9, 9 Septembre 1993, NEW YORK US pages 1053 - 1056 T.BRENNER ET.AL 'Integrated optical mode shape adapters in InGaAs/InP for efficient fiber-to-waveguide coupling'
- IEEE PHOTONICS TECHNOLOGY LETTERS, vol.6, no.2, Février 1994, NEW YORK US pages 208 - 210 N.YOSHIMOTO ET.AL. 'InGaAlAsInAs multiple quantum well phase modulator integrated with spot size conversion structure'
- 19TH EUROPEAN CONFERENCE ON OPTICAL COMMUNICATION, vol.2, 12 Septembre 1993, MONTREUX,SWITZERLAND pages 277 - 280 J.G.BAUER ET.AL. 'High responsivity integrated tapered waveguide PIN photodiode'
- APPLIED PHYSICS LETTERS., vol.55, no.15, 9 Octobre 1989, NEW YORK US pages 1495 - 1497 R.J.DERI 'Efficient fiber coupling to low-loss diluted multiple quantum well optical waveguides'

## Description

La présente invention concerne le domaine des dispositifs semi-conducteurs optoélectroniques.

Les dispositifs optoélectroniques réunissent des composants à fonctions optiques, tels que des lasers, guides optiques, modulateurs, photodiodes, et des composants à fonction électronique à base de transistors.

De nombreux dispositifs optoélectroniques sont conçus pour être couplés à des fibres optiques, en particulier dans le domaine des télécommunications optiques.

Cependant les dispositifs optoélectroniques et les fibres optiques possèdent des modes optiques différents : les modes optiques des circuits optiques intégrés aux dispositifs optoélectroniques sont généralement petits et elliptiques, typiquement 5 x 1µm, tandis que les modes des fibres optiques sont généralement circulaires et plus larges, typiquement d'un diamètre de 8 à 11µm.

Pour permettre un couplage correct entre fibre et dispositif optoélectronique il est donc nécessaire de prévoir entre ceux-ci un adaptateur modal servant à transformer - élargir ou rétrécir - le mode optique, afin d'adapter celui-ci.

Le couplage d'un mode à l'autre est donné par le carré de l'intégrale de recouvrement des deux champs.

Le couplage est idéalement égal à 1 si d'une part les deux modes sont identiques en tout point et d'autre part ils sont concentriques.

Il faut donc pour que le couplage soit optimal que l'un au moins des deux modes soit transformé et acquiert la géométrie de l'autre.

On peut pour cela travailler soit côté fibre, soit côté circuit optique.

Côté fibre, l'adaptateur de mode est formé généralement d'un lentillage de la fibre. Le couplage obtenu peut théroriquement être très bon, mais cependant les tolérances de positionnement sont alors très faibles vu que les deux modes à coupler sont petits. Typiquement 1 à 2µm d'erreur dans le positionnement entre la fibre et le circuit optoélectronique crée une perte de 90% en couplage. Prévoir l'adaptateur sur la fibre optique revient par conséquent à reporter le problème sur le montage. Par ailleurs, il est difficile de rendre le mode de fibre elliptique, ce qui fait que le rendement de couplage n'est jamais égal à 1.

Pour ces raisons, on a intérêt à travailler du côté du guide intégré sur le circuit optique et à réaliser la transformation sur le circuit optique lui-même.

Ceci permet de faire un traitement collectif du problème puisque des milliers de composants du même type peuvent être fabriqués simultanément. Il est possible de transformer le mode en un mode circulaire. Les tolérances de positionnement sont accrues par rapport à la méthode précédente vu que l'on couple deux modes plus larges que dans le cas fibre lentillée/guide.

L'adaptation de modes sur le circuit est connue en soit : différentes méthodes ont été proposées sur des composants optiques.

Sur ce point on peut se référer par exemple aux six documents suivants :
[1] G. Müller, L. Stoll, G. Wenger and M. Schienle, "Fisrt low loss InP/InGaAsP optical switch with integrated mode transformers", ECOC, Montreux, 1993, pp 37-40
[2] R.J. Deri, N. Yasuoka, M. Makiuchi, A. Kuramata and O. Wada, "Efficient fibre coupling to diluted multiple quantum well waveguides", Appl. Phys. Lett., 1989, 55, pp 1495-1497
[3] T.L. Koch, U. Koren, G. Eisenstein, M.G. Young, M. Oron, C.R. Giles and B.I. Miller, "Tapered waveguide lnGaAs/InGaAsP multiple quantum well lasers", IEEE Photonics Tech. Lett., 1990, 2, pp 88-90
[4] T. Brenner, W. Hunziker, M. Smit, M. Bachmann, G. Guekos and H. Melchior, "Vertical InP/InGaAsP tapers for low-loss optical fibre-waveguide coupling", Electron. Lett. Vol. 28, N°.22, October 1992, pp. 2040-2041
[5] R. Zengerle, H. Brückner, H. Olzhausen and A. Kohl, "Low-loss fibre-chip coupling by buried laterally tapered InP/InGaAsP waveguide structure", Electron. Lett. Vol. 28, n° 7, March 1992, pp631-632.
[6] J.G. Bauer et al., "High Responsivity Integrated Tapered Waveguide PIN Photodiode", CCOC 93.

Le document [3] décrit un dispositif conçu pour coupler un laser à une fibre optique et qui comporte pour cela un adaptateur de mode réalisé par gravure progressive en épaisseur de différentes couches composant l'adaptateur de mode.

Plus précisément, pour réaliser l'adaptation de mode sur le circuit optique, il faut résoudre deux problèmes:
a) avoir un guide de couplage dont le mode est adapté à la fibre,
b) réaliser la transformation adiabatique du mode de couplage en un mode plus petit, celui du circuit optique.

Pour résoudre le problème a) il a été suggéré d'obtenir un indice moyen de la zone guidante proche de l'indice de la zone de confinement. Pour cela on a proposé essentiellement deux moyens :
- obtenir directement un matériau proche, par exemple par dopage : InP/InP n+ (voir document [1]) ; il est en revanche (bien que théoriquement possible) difficile d'obtenir deux matériaux de compositions différentes ayant un indice proche ;
- diluer un matériau d'indice différent dans le matériau de confinement (voir document [2]), créant ainsi un matériau d'indice moyen proche de l'indice du matériau de confinement.

Pour résoudre le problème b), il a été suggéré de réduire et faire disparaître la couche guidante du circuit optique. Pour cela on a proposé plusieurs méthodes :
- tailler en biseau la couche guidante, par marche ou directement (voir documents [1, 3, 4]) ;
- tailler la couche guidante en pointe, grâce à une ou plusieurs lithographie et attaques, (voir document [5]).
- obtenir un indice moyen en segmentant le guide.

Le mode passe d'un état à l'autre par transformation adiabatique.

L'homme de l'art sait par ailleurs qu'il est souhaitable d'intégrer les composants à fonction électronique sur le circuit optique afin de pouvoir faire directement les conversions électriques/optiques, à l'émission ou à la réception. En particulier, pour des applications à haut débit cela permet de limiter les effets parasites dus au montage.

Cependant, malgré les nombreuses recherches conduites dans le domaine, en raison notamment des retombées potentielles pour les télécommunications à fibre optique, à la connaissance des inventeurs, aucune structure semi-conductrice complète intégrant des composants à fonction électronique et des adaptateurs modaux n'a encore été proposée.

Cela semble du au fait que jusqu'ici les contraintes liées à la fabrication des composants à fonction électronique à base de transistors et celles liées à la conception des adaptateurs modaux apparaissaient à priori incompatibles.

Notamment les composants à fonction électronique a base de transistors doivent être fabriqués sur substrat semi-isolant pour éviter toute capacité parasite, si l'on veut qu'ils soient performants. L'utilisation de structures du type InPn-/InPn+ n'est donc pas envisageable.

Par ailleurs, les couches de matériaux semi-conducteurs généralement utilisées pour la réalisation de composants actifs, tels que des transistors, sont absorbantes aux longueurs d'ondes optiques utilisées dans le domaine des télécommunications optiques.

De ce fait, avant la contribution de l'invention, l'homme de l'art ne pouvait envisager d'intégrer des adaptateurs modaux sur des structures comprenant des composants à fonction électronique, sans retirer les couches des composants à fonction électronique et refaire une épitaxie pour l'adaptateur modal et le guide.

Malgré les préjugés existants sur la base de l'état de la technique ainsi rappelé, les inventeurs se sont donnés pour but d'intégrer des composants à fonction purement électronique (par exemple des circuits à base de transistors) avec des circuits à fonction optique et des adaptateurs de modes.

Plus précisément, le but principal de l'invention est de permettre la réalisation sur un circuit optique, d'un adaptateur de mode d'une fibre optique à celui de ce circuit optique, afin de relaxer ainsi les tolérances de positionnement et augmenter l'efficacité de couplage.

Un but auxiliaire de l'invention est de proposer un procédé d'intégration de composants à fonction électronique, de composants à fonction optique et d'adaptateurs de mode, qui n'exige qu'un nombre limité d'épitaxies et de niveaux de masquages et qui facilite les problèmes d'alignement de niveaux.

Ce but est atteint dans le cadre de la présente invention grâce à un dispositif optoélectronique à semi-conducteur comportant au moins un composant à fonction électronique, au moins un composant à fonction optique et un adaptateur de mode associé à ce composant à fonction optique, les couches de matériau semi-conducteur constituant le composant à fonction électronique, font également partie des couches optiques dans la zone adaptateur modal, et d'autre part au moins au niveau de la zone adaptateur modal, ces couches de matériau semi-conducteur sont réalisées en un matériau non absorbantes à la longueur d'onde de travail du composant à fonction optique.

Selon une première variante de mise en oeuvre conforme à la présente invention, lesdites couches de matériau semi-conducteur faisant partie simutanément du composant à fonction électronique et des couches dans la zone adaptateur modal, sont réalisées en un matériau homogène qui présente un intervalle de bande interdite apparent tel que la longueur d'onde de travail du composant à fonction optique ne soit pas absorbée par ces couches.

Selon une seconde variante de mise en oeuvre conforme à la présente invention, lesdites couches de matériau semi-conducteur faisant partie simultanément du composant à fonction électronique et des couches dans la zone adaptateur modal sont réalisées en un matériau initialement homogène, ce matériau étant rendu localement non absorbant à la longueur d'onde de travail du composant à fonction optique, dans la partie optique.

Selon une troisième variante de mise en oeuvre conforme à la présente invention, lesdites couches de matériau semi-conducteur faisant partie simultanément du composant à fonction électronique et des couches dans la zone adaptateur modal sont réalisées en un matériau initialement homogène, ce matériau étant traité localement dans la partie composant à fonction électronique pour posséder un intervalle de bande interdite compatible avec cette fonction.

Ainsi un point fondamental de l'invention consiste à utiliser pour les composants à effet électronique, un matériau semi-conducteur compatible avec la structure optique. Pour cela les couches à petit intervalle de bande interdite des composants électroniques classiques sont remplacées par des couches dont l'intervalle apparent de bande interdite est supérieur et tel que la longueur d'onde de la lumière de travail ne soit pas absorbée, où ces couches sont traitées localement de sorte que le matériau soit rendu non absorbant dans la partie optique et/ou de sorte que le matériau présente un petit intervalle de bande interdite dans la partie composant électronique.

Selon une autre caractéristique avantageuse les différentes couches de matériau semi-conducteur constituant le dispositif conforme à la présente invention sont déposées par épitaxie sur un substrat présentant une marche gravée dont la hauteur est égale à la somme des épaisseurs des couches déposées par épitaxie, moins l'épaisseur des couches constituant le composant à fonction électronique.

Selon une autre caractéristique avantageuse de l'invention après épitaxie, les couches superposées à celles constituant le composant à fonction électronique sont retirées sur la partie haute de la marche gravée du substrat.

Selon une autre caractéristique avantageuse de la présente invention, l'adaptateur de mode est réalisé non point en taillant en pointe une couche guidante mais en utilisant une gravure totale par zones à pas variable d'un ruban de cette couche guidante. Cette méthode connue pour les guides diffusés est appliquée dans le cadre de l'invention, pour des sections gravées.

La présente invention concerne également un procédé de fabrication du dispositif.

Le document [7] Electronics Letters Vol. 29, N°4 Th SCHWANDER et Al. "Simple and low loss fibre to chip coupling by integrated field matching waveguide in InP" décrit un dispositif adaptateur de mode réalisé par dépôt d'une couche d'InP dopé Sn sur un substrat en InP semi isolant, puis dépôt d'une couche de guide en InP non intentionnellement dopée, gravure du guide, croissance d'une couche de quaternaire InGaAsP par épitaxie en phase liquide, gravure en pointe de cette couche, puis dépôt et gravure d'une couche de couverture en InP non intentionnellement dopée. La structure décrite dans ce document présente l'inconvénient de présenter une pointe dans la couche de guide quaternaire. Par ailleurs elle ne peut déplacer le mode en profondeur, puisque le guide petit mode est en face du large mode.

D'autres caractéristiques, buts et avantages de la présente invention apparaîtront à la lecture de la description détaillée qui va suivre, et en regard des dessins annexés donnés à titre d'exemples non limitatifs et sur lesquels :
- la figure 1 représente une vue en coupe verticale d'une structure optoélectronique à adaptateur de mode intégré, conforme à la présente invention,
- la figure 2 représente une vue en plan d'un élément adaptateur de mode taillé en pointe,
- la figure 3 représente une vue en plan d'un élément adaptateur de mode formé par gravure totale par zones à pas variable d'un ruban de la couche guidante, conforme à la présente invention,
- la figure 4 représente une vue partielle en perspective d'une structure optoélectronique conforme à la présente invention du type guide - PIN - HFET, et
- la figure 5 représente une vue partielle en perspective d'une structure optoélectronique conforme à la présente invention du type émetteur optique ou transducteur électrique/optique possédant une électronique de commande intégrée.

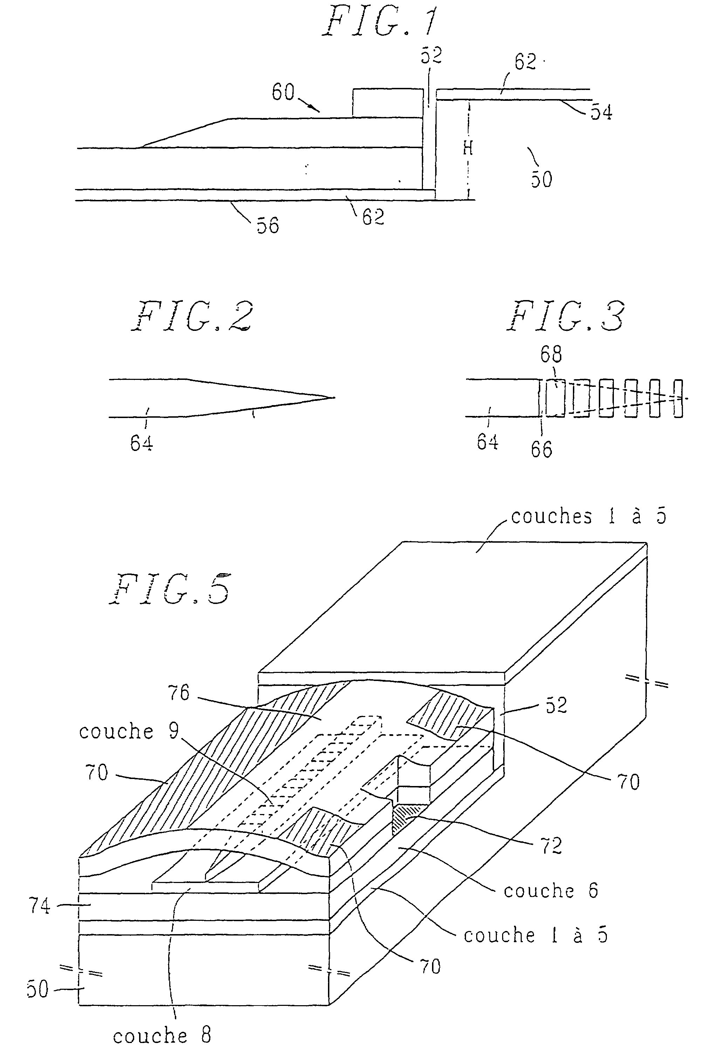

On va tout d'abord décrire la structure générale du dispositif conforme à la présente invention représentée sur la figure 1 annexée, ainsi que le procédé d'obtention de celle-ci.

La première étape du procédé consiste à réaliser un substrat semi-isolant 50 comportant une marche verticale droite 52.

Ensuite, on dépose par épitaxie, sur ce substrat 50, différentes couches superposées de matériaux semi-conducteurs. Ces couches superposées ont la référence générale 60 sur la figure 1.

Plus précisément, un groupe 62 de couches inférieures ainsi déposé a pour but d'assurer la fonction électronique à base de transistors, tandis que l'ensemble 60 des couches déposées par épitaxie, c'est-à-dire y compris le groupe 62 de couches inférieures précité, a pour but d'assurer la fonction optique.

La hauteur H de la marche 52 est égale à la somme des épaisseurs des couches 60 déposées par épitaxie moins l'épaisseur du groupe 62 de couches inférieures assurant la fonction électronique à base de transistors.

Après avoir déposé l'ensemble 60 des couches, par épitaxie, sur le substrat 50, les couches situées au-dessus du groupe 62 de couches inférieures, sont retirées, sur la partie haute 54 du substrat 50. Ainsi on obtient une structure planaire dans laquelle la surface supérieure du groupe 62 de couches restant sur la partie haute 54 du substrat affleure la surface supérieure de l'ensemble 60 des couches déposées sur la partie basse 56 du substrat.

Le composant à fonction électronique à base de transistors est réalisé sur la partie haute 54 du substrat à l'aide du groupe de couches 62. Le composant à fonction optique est réalisé sur la partie basse 56 du substrat à l'aide de l'ensemble 60 des couches déposées, et le cas échéant la coopération du substrat 50 lui-même.

La communication entre le composant à fonction électronique réalisé sur la partie haute 54 du substrat et le composant à fonction optique réalisé sur la partie basse 56 du substrat est obtenue au niveau des couches supérieures du composant à fonction optique placées en regard des couches 62 du composant à fonction électronique.

Comme on l'a indiqué précédemment, dans le cadre de l'invention, les couches 62 de matériaux semi-conducteurs constituant le composant à fonction électronique sont utilisées simultanément pour former les couches optiques inférieures dans la zone adaptateur modal. Cependant, du fait que les couches de matériaux semi-conducteurs 62 qui forment le composant à fonction électronique, présentent un intervalle de bande interdite apparent tel que la longueur d'onde de travail ne soit pas absorbée par ces couches, au moins dans la partie optique, l'utilisation simultanée des couches 62 dans le composant à fonction électronique et dans le composant à fonction optique, ne perturbe pas le fonctionnement de ce dernier.

Le dispositif conforme à la présente invention permet une conversion électrique/optique directe à l'émission ou à la réception.

De plus, la présente invention permet d'épitaxier le composant à fonction électronique directement sur le substrat semi-isolant, ce qui évite toute capacité parasite.

Grâce à la présente invention, les couches du composant à fonction électronique sont accessibles directement sur la partie haute 54 de la structure. Ceci permet de réaliser la grille de dimension submicronique de ce composant grâce à tout procédé classique.

Les composants à fonction électronique formés des couches 62 déposées sur la partie haute 54 du substrat peuvent constituer par exemple des transistors de différents types, tels que des transistors à effet de champ ou transistors bipolaires.

Par rapport aux solutions envisageables antérieurement sur la base de l'état de la technique, la présente invention permet l'intégration de l'adaptateur modal sur un substrat comprenant un composant à fonction électronique, sans décaper les couches de ce dernier et refaire une épitaxie pour réaliser l'adaptateur modal et le guide associé.

Une caractéristique essentielle de l'invention réside donc dans le remplacement des couches à petit intervalle de bande interdite utilisées classiquement pour la réalisation de transistors, par des couches d'intervalle de bande interdite apparent supérieur, ou par un traitement local des couches de matériau semi-conducteur utilisées simultanément pour former le composant à fonction électronique et l'adaptateur de mode, afin de rendre ce matériau compatible respectivement avec ladite fonction électronique et ladite fonction d'adaptation de mode.

Cet intervalle de bande interdite apparent peut correspondre directement à l'intervalle de bande interdite d'un matériau utilisé, ou encore peut correspondre à l'intervalle de bande interdite résultant d'effets quantiques.

Cet intervalle de bande interdite apparent doit être adapté de telle sorte que la longueur d'onde où l'on travaille la lumière ne soit pas absorbée au niveau du composant à fonction optique.

A titre d'exemple non limitatif, l'intervalle de bande interdite apparent des couches 62 formant le composant à fonction électronique peut être de l'ordre de 1,4µm pour un travail dans la fenêtre 1,52-1,57µ.

Les couches du composant à fonction électronique sont alors suffisamment fines pour constituer un matériau de type dilué. On peut, en ajoutant quelques couches supplémentaires dans la structure guide, modifier à souhait la structure du mode.

Le guidage du mode large se fait en partie dans le substrat 50, ce qui réduit l'épaisseur de couches épitaxiées nécessaires et donc permet d'avoir une planarisation suffisante pour réaliser les composants à fonction électronique.

Les performances de ces composants peuvent être globalement les mêmes qu'avec des structures à petit intervalle de bande interdite, si l'on optimise la structure.

Par exemple pour des transistors à effet de champ à canal quaternaire, les performances peuvent être légèrement inférieures en terme de fréquence de coupure mais seront en revanche meilleure en terme de bruit.

Le couplage mode large à mode étroit peut être réalisé par l'une quelconque des méthodes décrites antérieurement dans l'état de la technique, voir plusieurs de ces méthodes combinées.

Ainsi, le couplage mode large à mode étroit peut être obtenu en taillant en biseau la couche guidante, par marches ou directement, ou encore en taillant la couche guidante en pointe, grâce à une ou plusieurs lithographies et attaques par exemple.

Sur la figure 2 on a schématisé ainsi la taille classique en pointe de la couche guidante 64 pour un couplage mode large à mode étroit.

Cependant, dans le cadre de la présente invention, il est proposé également un procédé différent des méthodes antérieurement envisagées pour assurer ce couplage.

En effet, la taille des pointes qui doivent être atteintes pour déconfiner les modes, de l'ordre de 20nm, nécessite l'emploi d'insolation sur tranche, très contraignante, lors de la réduction en pointe de la couche guidante 64.

Pour éliminer ce problème, il est proposé, dans le cadre de l'invention, comme schématisé sur la figure 3, non pas de tailler la couche guidante en pointe, mais d'utiliser une gravure totale par zones à pas variables du ruban 64 composant cette couche guidante.

Par "pas variables", on entend que les zones 66 gravées, c'est-à-dire éliminées totalement, ont des épaisseurs progressivement croissantes en éloignement du ruban 64 composant la couche guidante et que par ailleurs les éléments discrets 68 de cette couche guidante 64 préservés entre deux zones gravées 68 ont inversement des épaisseurs progressivement décroissantes en éloignement du ruban 64 composant la couche guidante. La structure finale obtenue schématisée sur la figure 3 présente le même indice moyen qu'une couche guidante physiquement taillée en pointe comme illustré sur la figure 2, sans présenter néanmoins les contraintes de cette dernière.

Il faut noter que la présente invention s'applique non seulement au couplage d'une structure optoélectronique avec une fibre clivée, mais également au couplage d'une structure optoélectronique avec une fibre lentillée de taille de mode raisonnable, par exemple 5-8µm. Une telle fibre lentillée peut être obtenue aisément à l'aide de techniques connues de l'homme de l'art, et l'invention permet dans ce contexte de relacher notablement les tolérances de positonnement. Pour cela, bien entendu, le guide de couplage doit permettre d'obtenir un mode circulaire.

La présente invention peut trouver application dans la réalisation de nombreuses structures optoélectroniques.

Par la suite, on va décrire l'application de l'invention, d'une part à la réalisation d'un circuit de détection type guide-PIN-HFET, et d'autre part à la réalisation d'un circuit d'émission type émetteur optique ou transducteur électrique/optique possédant une électronique de commande intégrée.

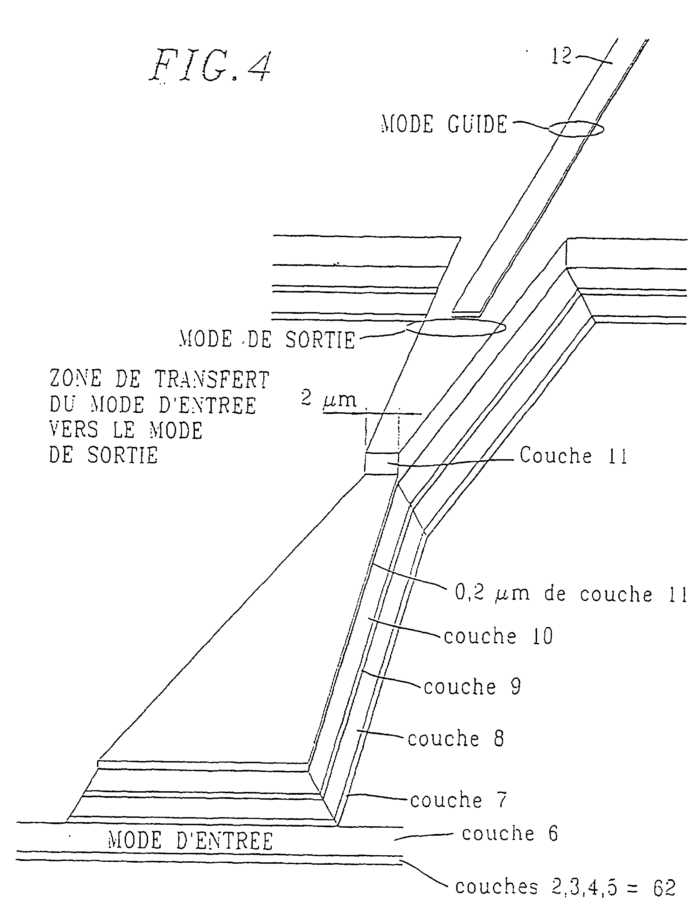

On va tout d'abord décrire la réalisation de la structure de détection guide-PIN-HFET, en regard de la figure 4.

La première étape du procédé consiste à réaliser un substrat 50 gravé présentant une marche verticale droite 52.

Puis, l'on réalise par épitaxie le dépôt des seize couches définies dans le tableau I.

**TABLEAU I**

| couche | matériau | Gap | épaisseur | dopage | type | indice | commentaire |
|---|---|---|---|---|---|---|---|
| 16 | GaInAs | | 250A | <5.10¹⁵ | n- | 3.535-i0.083 | contact |
| 15 | InP | | 0.3µ | <5.10¹⁵ | n- | 3.172 | fenêtre diffusion |
| 14 | GaInAs | | 0.4µ | <5.10¹⁵ | n- | 3.535-i0.083 | absorbant |
| 13 | GaInAsP | 1.37µ | 0.3µ | 5.10¹⁸ | n+ | >3.381 | contact n+ |
| 12 | InP | | 250A | <5.10¹⁵ | n- | 3.172 | stop gravure |
| 11 | GaInAsP | 1.3µ | 0.65µ | <5.10¹⁵ | n- | 3.381 | guide |
| 10 | InP | | 0.8µ | <5.10¹⁵ | n- | 3.172 | buffer |
| 9 | GaInAsP | 1.3µ | 0.05µ | <5.10¹⁵ | n- | 3.381 | buffer |
| 8 | InP | | 0.8µ | <5.10¹⁵ | n- | 3.172 | buffer |
| 7 | GaInAsP | 1.3µ | 0.1µ | <5.10¹⁵ | n- | 3.381 | buffer |
| 6 | InP | | 0.8µ | <5.10¹⁵ | n- | 3.172 | buffer |
| 5 | GaInAsP | 1.37µ | 250A | <5.10¹⁵ | n- | 3.4 | contact |
| 4 | AlInAs | | 500A | <5.10¹⁵ | n- | 3.21 | grille |
| 3 | GaInAsP | 1.3µ | 500A | 4.10¹⁷ | n | 3.381 | canal |
| 2 | GaInAsP | 1.3µ | 500A | 4.10¹⁷ | n | 3.381 | canal |
| 1 | InP | | 500A | .10¹⁷ | S.I. | 3.169 | buffer |
| | substrat | | | | | 3.169 | |

La hauteur H de la marche du substrat 50 gravée correspond à l'épaisseur des couches 6 à 16, soit dans l'exemple particulier défini au tableau I, 4,2µm.

Les couches 1 à 5 déposées sur la partie haute 54 du substrat sont destinées à réaliser un transistor à effet de champ (FET).

Les couches 1 à 10 (soient notamment les couches 1 à 5 précitées) déposées sur la partie basse 56 du substrat sont destinées à constituer l'adaptateur de mode ; les couches 11 à 12 superposées sont destinées à constituer un guide optique ; et les couches 13 à 15 sont destinées à constituer un élément PIN. Ainsi, l'ensemble des couches déposées sur la partie basse 56 du substrat constitue un composant à fonction optique.

Aprés dépôt des couches 1 à 16 par épitaxie, les couches 6 à 15 sont retirées de la partie haute 54. On obtient alors une structure planaire, la surface supérieure de la couche 5 déposée sur la partie haute 54 affleurant la surface supérieure de la couche 16 déposée sur la partie basse 56.

Les fenêtres p+ des PIN sont diffusées.

Les contacts p, n et le contact de grille des transistors FET sont réalisés par trois métallisations successives sur la partie haute.

Le mesa ou ruban FET est gravé dans la partie haute.

Les couches 13 à 15 servant à la PIN sont retirées de la partie guide.

On retire ensuite la couche 11 en la taillant en pointe dans la zone transformation de mode, et on grave latéralement une partie de la couche 11, par exemple une couche de 0,2µm d'épaisseur, pour former le guide dans la zone large mode.

Plus précisément, selon le mode de réalisation préférentiel représenté sur la figure 4 annexée, l'adaptateur de mode est gravé en forme de sablier.

L'adaptateur de mode comprend ainsi 3 parties principales : une entrée, une zone de décroissance et une zone de croissance.

La partie d'entrée est adaptée pour guider un mode large. A ce niveau les couches électroniques 62, soit 1 à 6, participent à la définition de l'adaptateur de mode.

Le mode large est centré sur la couche 6.

Dans la zone de décroissance qui suit, le ruban décroît en largeur dans le sens de la propagation vers le composant électronique, pour pousser le mode en profondeur. Au niveau de cette zone de décroissance en largeur, la couche 11 est également réduite en épaisseur, par exemple à 0,2µm.

La région de transition entre la zone de décroissance et la zone de croissance n'est pas formée d'une pointe (démarrant à 0µm par définition) mais d'une pointe tronquée, par exemple démarrant avec une largeur de l'ordre de 2µm. Une telle extrémité tronquée est plus facile à réaliser qu'une pointe pure, ou encore qu'une pointe de faible largeur (1µm par exemple comme décrit dans le document [6] au nom de Bauer).

La réalisation de l'adaptateur de mode en forme de sablier est donc particulièrement importante parce qu'elle facilite la technologie. Elle permet par exemple l'utilisation d'une technique de lithographie optique peu coûteuse.

La structure adaptateur de mode conforme à la présente invention peut être réalisée par épitaxie unique. Elle permet d'éviter la réalisation d'une pointe comme dans le cas du document Schwander. Cette pointe est évitée en poussant le mode vers le bas comme indiqué par la suite grâce à une faible largeur de l'ordre de 2µm du centre du sablier, alors que selon Schwander, la zone de plus faible largeur est de l'ordre d'au moins 7,5 µm. De plus le déplacement du mode en profondeur dans le cadre de la présente invention est obtenu grâce à la présence du guide de circuiterie au dessus de la structure et à la présence du guide de couplage en dessous de celle-ci.

Le mode se retrouve dans sa position la plus profonde lorsqu'il atteint la gorge la plus étroite du sablier. On obtient à ce niveau la transition mode large-mode guidé.

Puis vient la zone de croissance, au niveau de laquelle le ruban croit en largeur dans le sens de la propagation vers le composant électronique. Par ailleurs, au niveau de la zone de croissance, la couche 11 est préservée sur toute son épaisseur, soit 0,65µm. Ainsi à partir de la gorge du sablier, on trouve, dans le sens de la propagation, sur la zone de croissance, une première partie dans laquelle la couche 11 dépourvue de la couche 12 présente toute son épaisseur soit 0,65µm et une seconde partie dans laquelle la couche 11 et la couche 12 superposée forment en combinaison un guide de 0,9µm d'épaisseur.

Le passage du mode large d'entrée (centré dans la couche 6) à un mode plus étroit (centré dans la couche 11) se fait dans la zone de croissance, en remontant.

Le signal acheminé dans ce guide est traité optiquement et ensuite électroniquement.

Ainsi la couche 11 servant de guide évolue en épaisseur en passant de 0,2µm en entrée d'adaptateur à 0,65µm dans la zone de transition de mode qui correspond à la gorge la plus étroite du sablier, et enfin à 0,9µm d'épaisseur au niveau du ruban guide qui aboutit au composant à fonction optique.

Il faut noter que l'utilisation de couches minces 7 et 9 dans l'adaptateur de mode permet de diluer encore plus celui-ci.

Il est en effet avantageux dans le cadre de la présente invention, que l'adaptateur de mode soit formé d'un quaternaire dilué (et non pas de puits quantiques dilués) par exemple sous forme de 3 fines couches de 250Angströms de quaternaire 1,3 séparées par des couches InP de l'ordre de 1 µm.

Comme on le voit sur la figure 4, on grave latéralement une partie des couches 10, 9, 8 de manière auto-alignée en se servant de la couche 11 comme masque pour former l'adaptateur de mode en forme de sablier.

Les plots d'interconnection sont ensuite tirés en utilisant des ponts à air, connus de l'homme de l'art.

Le procédé précité permet d'obtenir un récepteur haut débit très sensible, avec pertes de couplage éliminées et des tolérances de couplage accrues, d'au moins un facteur trois.

Le procédé qui vient d'être décrit est extensible notamment à la fabrication de barrettes de détecteurs.

On va maintenant décrire la structure formant émetteur optique ou transducteur électrique/optique possédant une électronique de commande intégrée et son procédé d'obtention en regard de la figure 5 annexée.

De façon comparable à l'exemple antérieur, on commence par réaliser un substrat 50 semi-conducteur à marche verticale droite gravée. Puis l'on procède au dépôt par épitaxie des couches 1 à 12 indiquées dans le tableau II. L'épaisseur de la marche 52 gravée dans le substrat 50 correspond à l'épaisseur des couches 6 à 14, soit 2,3µm dans le cadre de cet exemple.

Les couches 1 à 5 déposées sur la partie haute 54 du substrat ont pour but de réaliser des transistors à effet de champ. L'ensemble des couches déposées sur la partie basse 56 du substrat a pour but de réaliser une structure optique type laser.

Pour cela on procède à la configuration d'un réseau dans les couches 10, 12, par holographie.

**TABLEAU II**

| couche | matériau | Gap | épaisseur | dopage | type | indice | commentaire |
|---|---|---|---|---|---|---|---|
| 12 | InP | | 250A | <5.10¹⁵ | n- | 3.172 | réseau |
| 11 | GaInAsP | 1.3µ | 250A | <5.10¹⁵ | n- | 3.381 | réseau |
| 10 | InP | | 250A | <5.10¹⁵ | n- | 3.172 | réseau |
| 9 | GaInAsP | 1.5µ | 0.2µ | <5.10¹⁵ | n- | 3.524 | laser |
| 8 | InP | | 0.5µ | 10¹⁸ | n+ | 3.13 | contact n laser |
| 7 | InGaAsP | | 0.05µ | 10¹⁸ | n+ | 3.35 | contact n laser |
| 6 | InP | | 0.5µ | 10¹⁸ | n+ | 3.13 | contact n laser |
| 5 | GaInAsP | 1.37 | 250A | <5.10¹⁵ | n- | 3.4 | contact FET |
| 4 | AlInAs | | 500A | <5.10¹⁵ | n- | 3.21 | grille |
| 3 | GaInAsP | 1.3µ | 500A | 4.10¹⁷ | n | 3.381 | canal |
| 2 | AlInAs | | 300A | <5.10¹⁵ | n- | 3.21 | buffer |
| 1 | InP | | 500A | .10¹⁷ | S.I. | 3.169 | buffer |
| | substrat | | | | | 3.169 | |

Le ruban laser est gravé dans la couche 9, sur la partie basse. Simultanément on retire les couches 8 à 12 de la région des transistors à effet de champ, sur la partie haute.

De plus, la couche active 9 est taillée en pointe dans la zone d'adaptation de mode, comme on le voit sur la figure 5 ou en variante, pour faciliter la réalisation, il est possible d'utiliser un adaptateur de mode conformé en sablier, comme schématisé sur la figure 4 et décrit précédemment.

Le ruban large mode formé par les couches 7, 8 est gravé en ruban, en protégeant la partie dévolue aux plots n+.

Puis on procède à une reprise d'épitaxie (sélective ou non), du p+ laser constitué des deux couches 13 et 14 mentionnées dans le tableau III.

**TABLEAU III**

| couche | marériau | Gap | épaisseur | dopage | type | indice | commentaire |
|---|---|---|---|---|---|---|---|
| 14 | GaInAs | | 250A | <5.10¹⁷ | p+ | 3.535 | contact p laser |
| 13 | InP | | 2µm | <5.10¹⁷ | p+ | 3.17 | contact p laser |

On dégage ensuite la zone des transistors à effet de champ, sur la partie haute 54 du substrat en retirant les couches 6, 7 et 13 à 14 à ce niveau. Les couches 6 à 14 ayant été retirées ainsi de la partie haute 54, on obtient une structure planaire, c'est-à-dire que la surface supérieure de la couche 5, en partie haute 54, affleure la surface supérieure de la couche 14, en partie basse du substrat.

On réalise l'isolation de la structure laser avec une implantation proton, de façon connue de l'homme de l'art, en laissant un chemin pour le contact n face avant.

Dans la zone laser, à côté du ruban gravé dans la couche 9, on ouvre un trou pour pouvoir récupérer le contact n réalisé dans la couche 7.

Les contacts p, n et la grille du transistor sont formés par trois métallisations successives sur la partie haute du substrat.

Le ruban du transistor à effet de champ est ensuite gravé.

Puis on grave dans la partie large mode une partie de la couche 11, la couche 12 ayant été retirée, pour réaliser le confinement latéral. Enfin, les plots d'interconnection sont tirés en utilisant des ponts à air.

Sur la figure 5 annexée, on a référencé en 70 et sous forme hachurée, les zones implantées proton d'isolation, en 72 l'ouverture réalisée à côté du ruban dans la zone laser pour récupérer le contact n, en 74 la face de couplage avec le guide large mode, dans la couche 6 et en 76 le contact p.

On peut éventuellement rajouter des couches fines en quaternaire InGaAsP dans la couche 6 et la couche 11 pour élargir et arrondir le mode.

La couche 7 peut être remplacée par des puits quantiques ou autres structures laser plus performantes.

Cette méthode est bien entendu adaptable à d'autres types de structures laser.

On obtient avec le procédé précédemment décrit un émetteur optique ou transducteur électrique/optique possédant une électronique de commande intégrée avec des tolérances et une efficacité de couplage accrue.

Cette méthode est extensible à la fabrication de barrettes d'émetteurs optiques ou transducteurs électriques/optiques possédant une électronique de commande intégrée.

Bien entendu la présente invention n'est pas limitée aux modes de réalisation particuliers qui viennent d'être décrits mais s'étend à toute variante conforme à son esprit.

Selon les modes de réalisation décrits précédemment, lesdites couches 62 de matériau semi-conducteur utilisées simultanément pour former le composant à fonction électronique et des couches dans la zone adaptateur modal, sont réalisées en un matériau homogène qui présente un intervalle de bande interdite apparent tel que la longueur d'onde de travail ne soit pas absorbée par ces couches.

Cependant en variante, on peut traiter localement ces couches de sorte que le matériau soit rendu non absorbant dans la partie optique et/ou de sorte que le matériau présente un petit intervalle de bande interdite dans la partie composant électronique.

Ainsi, selon une première mise en oeuvre, lesdites couches 62 de matériau semi-conducteur utilisées simultanément pour former le composant à fonction électronique et des couches dans la zone adaptateur modal sont réalisées en un matériau initialement homogène, ce matériau étant rendu localement non absorbant à la longueur d'onde de travail dans la partie optique.

Selon une seconde mise en oeuvre, lesdites couches 62 de matériau semi-conducteur utilisées simultanément pour former le composant à fonction électronique et des couches dans la zone adaptateur modal sont réalisées en un matériau initialement homogène, ce matériau étant traité localement dans la partie composant à fonction électronique pour posséder un intervalle de bande interdite compatible avec cette fonction.

De tels traitements du matériau semi-conducteur peuvent être formés de toutes techniques connues de l'homme de l'art, par exemple une épitaxie localement sélective, un mélange partiel ou total des matériaux constituants la couche concernée etc ... Ces traitements sont décrits par exemple dans les documents :
[8] Moo-Sung Kim, Catherine Caneau, Etienne Colas and Rajaram Bhat, "Selective area growth of InGaAsP by OMVPE", Journal of Crystal Growth 123 (1992) 69-74, et
[9] Robert L. Thornton, William J. Mosby and Thomas L. Paoli, "Monolithic Waveguide Coupled Cavity Lasers and Modulators Fabricated by Impurity Induced Disordering", Journal of Lightwave Techonology, vol. 6, n° 6, June 1988.

## Revendications

1. Dispositif optoélectronique à semi-conducteur comportant au moins un composant à fonction purement électronique (62), au moins un composant à fonction optique (60) et un adaptateur de mode associé à ce composant à fonction optique, les couches (62) du matériau semi-conducteur constituant le composant à fonction électronique, faisant également partie des couches optiques dans la zone adaptateur modal, au moins au niveau de la zone adaptateur modal, ces couches de matériau semi-conducteur (62) étant réalisées en un matériau non absorbant à la longueur d'onde de travail du composant à fonction optique.

2. Dispositif selon la revendication 1, dans lequel lesdites couches (62) de matériau semi-conducteur faisant partie simultanément du composant à fonction électronique et des couches dans la zone adaptateur modal, sont réalisées en un matériau homogène qui présente un intervalle de bande interdite apparent tel que la longueur d'onde de travail du composant à fonction optique ne soit pas absorbée par ces couches.

3. Dispositif selon la revendication 1, dans lequel lesdites couches (62) de matériau semi-conducteur faisant partie simultanément du composant à fonction électronique et des couches dans la zone adaptateur modal sont réalisées en un matériau initialement homogène, ce matériau étant rendu localement non absorbant à la longueur d'onde de travail du composant à fonction optique, dans la partie optique.

4. Dispositif selon la revendication 1, dans lequel lesdites couches (62) de matériau semi-conducteur faisant partie simultanément du composant à fonction électronique et des couches dans la zone adaptateur modal sont réalisées en un matériau intialement homogène, ce matériau étant traité localement dans la partie composant à fonction électronique pour posséder un intervalle de bande interdite compatible avec cette fonction.

5. Dispositif selon l'une des revendications 3 ou 4, dans lequel les traitements des couches de matériau semi-conducteur (62) afin de rendre celui-ci localement non-absorbant à la longueur d'onde de travail, dans la partie optique, et/ou de donner à ce matériau un intervalle de bande interdite compatible avec la fonction électronique, sont choisis dans le groupe comprenant une épitaxie localement sélective et un mélange partiel ou total des matériaux constituants la ou les couches concernées.

6. Dispositif selon l'une des revendications 1 à 5, comportant un substrat (50) présentant une marche gravée (52).

7. Dispositif selon la revendication 6, dans lequel la hauteur (H) de la marche gravée (52) est égale à la somme des épaisseurs des couches (60) déposées, moins l'épaisseur des couches (62) constituant le composant à fonction électronique.

8. Dispositif selon l'une des revendications 1 à 7, dans lequel le substrat (50) est de type intrinséquement non absorbant pour intervenir dans le guidage du mode large.

9. Dispositif selon l'une des revendications 1 à 8, dans lequel l'adaptateur de mode est gravé en forme de sablier.

10. Dispositif selon la revendication 9, dans lequel l'adaptateur de mode en sablier comprend une partie d'entrée large mode, une zone de décroissance en largeur pour pousser le mode en profondeur et une zone de croissance en largeur qui permet le transfert du mode large vers un guide.

11. Dispositif selon l'une des revendications 9 ou 10, dans lequel l'adaptateur de mode en forme de sablier comprend une gorge de largeur non nulle.

12. Dispositif selon la revendication 11, dans lequel la largeur de la gorge de l'adaptateur en forme de sablier est de l'ordre de 2µm.

13. Dispositif selon l'une des revendications 9 à 12, dans lequel une couche superficielle de l'adaptateur de mode est gravée en épaisseur dans sa zone de décroissance en largeur.

14. Procédé de fabrication d'un dispositif optoélectronique conforme à l'une des revendications 1 à 13, comprenant les étapes consistant à :
- déposer par épitaxie sur un substrat gravé (50) un ensemble de couches en matériau semi-conducteur,
- retirer de la partie haute du substrat les couches de matériau semi-conducteur déposées, superposées à un groupe (62) inférieur destiné à constituer un composant à fonction électronique, et
- conformer les couches (60) déposées sur la partie basse du substrat en adaptateur modal, de sorte que les couches (62) de matériau semi-conducteur constituant le composant à fonction électronique soient utilisées simultanément pour former des couches optiques dans la zone adaptateur modal, au moins au niveau de la zone adaptateur modal, ces couches de matériau semi-conducteur étant adaptées pour être non absorbantes à la longueur d'onde de travail du composant à fonction optique.

15. Procédé selon la revendication 14, dans lequel la hauteur (H) de marche gravée sur le substrat (50) est égale ou proche de la somme des épaisseurs des couches déposées par épitaxie, moins l'épaisseur des couches (62) constituant le composant à fonction électronique.

16. Procédé selon l'une des revendications 14 ou 15, dans lequel l'adaptateur de mode est conformé par gravure totale par zones à pas variables (66) d'un ruban de la couche guidante.

17. Procédé selon l'une des revendications 14 à 16, comprenant l'étape consistant à former un adaptateur de mode en sablier comprenant une partie d'entrée large mode, une zone de décroissance en largeur pour pousser le mode en profondeur et une zone de croissance en largeur qui permet le transfert du mode large vers un guide.

18. Procédé selon la revendication 17, dans lequel l'adaptateur de mode en forme de sablier comprend une gorge de largeur non nulle.

19. Procédé selon la revendication 18, dans lequel la largeur de la gorge de l'adaptateur en forme de sablier est de l'ordre de 2µm.

20. Procédé selon l'une des revendications 17 à 19, dans lequel l'adaptateur de mode comprend des couches minces pour diluer le mode.

21. Procédé selon l'une des revendications 17 à 20, dans lequel une couche superficielle de l'adaptateur de mode est gravée en épaisseur dans sa zone de décroissance en largeur.

22. Procédé selon la revendication 21, dans lequel l'épaisseur de la couche superficielle de l'adaptateur de mode est de l'ordre de 0,2µm dans la zone de décroissance en largeur.

23. Procédé selon l'une des revendications 21 ou 22, dans lequel l'épaisseur de la couche superficielle de l'adaptateur de mode est de l'ordre de 2µm dans sa zone de croissance en largeur.

24. Utilisation du dispositif selon l'une des revendications 1 à 13, pour la réalisation d'un ensemble guide-PIN-HFET.

25. Utilisation d'un dispositif selon l'une des revendications 1 à 13, pour la réalisation d'un émetteur optique ou transducteur électrique/optique possédant une électronique de commande intégrée.

## Claims

1. A semiconductor opto-electronic device including at least one purely electronic function component (62), at least one optical function component (60) and a mode transformer associated with the optical function component, the layers (62) of the semiconductor material constituting the electronic function component also forming part of the optical layers in the mode transformer zone and, at least in the mode transformer zone, these semiconductor material layers (62) being made of a material that is non-absorbent at the operating wavelength of the optical function component.

2. A device according to claim 1, in which said semiconductor material layers (62) simultaneously forming part of the electronic function component and layers in the mode transformer zone are made from a homogeneous material which has an apparent forbidden band gap such that the operating wavelength of the optical function component is not absorbed by these layers.

3. A device according to claim 1, in which said semiconductor material layers (62) simultaneously forming part of the electronic function component and layers in the mode transformer zone are made from a material that is initially homogeneous and is rendered locally non-absorbent at the operating wavelength of the optical function component in the optical part.

4. A device according to claim 1, in which said semiconductor material layers (62) simultaneously forming part of the electronic function component and layers in the mode transformer zone are made from a material that is initially homogeneous and is treated locally in the electronic function component part to have a forbidden band gap compatible with that function.

5. A device according to claim 3 or 4, in which the treatment of the semiconductor material layers (62) to render them locally non-absorbent at the operating wavelength in the optical part and/or to impart to the material a forbidden band gap compatible with the electronic function are selected from the group comprising locally selective epitaxy and total or partial mixing of the materials constituting the layer or layers concerned.

6. A device according to any one of claims 1 to 5, including a substrate including an etched step (52).

7. A device according to claim 6, in which the height (H) of the etched step (52) is equal to the sum of the thicknesses of the deposited layers (60) less the thickness of the layers (62) constituting the electronic function component.

8. A device according to any one of claims 1 to 7, in which the substrate (50) is of the intrinsically non-absorbent type to contribute to guiding of the wide mode.

9. A device according to any one of claims 1 to 8, in which the mode transformer is etched in the shape of an hourglass.

10. A device according to claim 9, in which the hourglass-shape mode transformer has a wide mode entry part, a zone of decreasing width to push down the mode and a zone of increasing width to transfer the wide mode to a waveguide.

11. A device according to claim 9 or 10, in which the hourglass-shape mode transformer has a neck of non-null width.

12. A device according to claim 11, in which the width of the neck of the hourglass-shape transformer is in the order of 2 µm.

13. A device according to any one of claims 9 to 12, in which a surface layer of the mode transformer is etched in its thickness in its zone of decreasing width.

14. A method of fabricating an opto-electronic device according to any one of claims 1 to 13, including the steps of:
- depositing layers of semiconductor material epitaxially onto an etched substrate (50),
- removing from the upper part of the substrate the deposited layers of semiconductor material on top of a lower group (62) later to form an electronic function component, and
- conforming the layers (60) deposited on the lower part of the substrate as a mode transformer so that the layers (62) of semiconductor material constituting the electronic function component simultaneously form optical layers in the mode transformer zone and, at least in the mode transformer zone, these semiconductor material layers are non-absorbent at the operating wavelength of the optical function component.

15. A method according to claim 14, in which the height (H) of the etched step on the substrate (50) is equal or nearly equal to the sum of the thicknesses of the layers deposited epitaxially less the thickness of the layers (62) constituting the electronic function component.

16. A method according to claim 14 or 15, in which the mode transformer is formed by total etching of a stripe of the guide layer in zones (66) with a varying pitch.

17. A method according to any one of claims 14 to 16, including the step of forming an hourglass-shape mode transformer having a wide mode entry part, a zone of decreasing width to push down the mode and a zone of increasing width to transfer the wide mode to a waveguide.

18. A method according to claim 17, in which the hourglass-shape mode transformer has a neck of non-null width.

19. A method according to claim 18, in which the width of the neck of the hourglass-shape transformer is in the order of 2 µm.

20. A method according to any one of claims 17 to 19, in which the mode transformer includes thin layers to dilute the mode.

21. A method according to any one of claims 17 to 20, in which a surface layer of the mode transformer is etched in its thickness in its zone of decreasing width.

22. A method according to claim 21, in which the thickness of the surface layer of the mode transformer is in the order of 0.2 µm in the zone of decreasing width.

23. A method according to claim 21 or 22, in which the thickness of the surface layer of the mode transformer is in the order of 2 µm in the zone of increasing width.

24. Use of the device according to any one of claims 1 to 13, for making a waveguide-PIN-HFET.

25. Use of a device according to any one of claims 1 to 13, for making an optical emitter or an electrical/optical transducer with integrated control electronics.

## Patentansprüche

1. Optoelektronische Halbleitervorrichtung mit wenigstens einer Komponente mit rein elektronischer Funktion (62), wenigstens einer Komponente mit optischer Funktion (60) und einem dieser Komponente mit optischer Funktion zugeordneten Modenadapter, wobei die Schichten (62) des Halbleitermaterials, die die Komponente mit elektronischer Funktion bilden, auch Teil der optischen Schichten in der Modenadapterzone sind, wobei wenigstens im Bereich der Modenadapterzone diese Schichten aus Halbleitermaterial (62) aus einem bei der Arbeitswellenlänge der Komponente mit optischer Funktion nicht-absorbierenden Material gebildet sind.

2. Vorrichtung nach Anspruch 1, bei der die Schichten (62) aus Halbleitermaterial, die gleichzeitig Teil der Komponente mit elektronischer Funktion und der Schichten in der Modenadapterzone sind, aus einem homogenen Material hergestellt sind, das ein solches scheinbares verbotenes Bandintervall aufweist, dass die Arbeitswellenlänge der Komponente mit optischer Funktion von diesen Schichten nicht absorbiert wird.

3. Vorrichtung nach Anspruch 1, bei der die Schichten (62) aus Halbleitermaterial, die gleichzeitig Teil der Komponente mit elektronischer Funktion und der Schichten in der Modenadapterzone sind, aus einem ursprünglich homogenen Material gebildet sind, das bei der Arbeitswellenlänge der Komponente mit optischer Funktion im optischen Bereich lokal nicht-absorbierend gemacht ist.

4. Vorrichtung nach Anspruch 1, bei der die Schichten (62) aus Halbleitermaterial, die gleichzeitig Teil der Komponente mit elektronischer Funktion und der Schichten in der Modenadapterzone sind, aus einem ursprünglich homogenen Material gebildet sind, wobei das Material im Bereich der Komponente mit elektronischer Funktion lokal behandelt ist, um ein verbotenes Bandintervall aufzuweisen, das mit dieser Funktion vereinbar ist.

5. Vorrichtung nach einem der Ansprüche 3 oder 4, bei der die Bearbeitungen der Schichten aus Halbleitermaterial (62), um dieses bei der Arbeitswellenlänge im optischen Bereich lokal nicht-absorbierend zu machen und/oder diesem Material ein mit der elektronischen Funktion kompatibles verbotenes Bandintervall zu verleihen, aus der Gruppe gewählt sind, die eine lokal selektive Epitaxie und eine teilweise oder vollständige Durchmischung der die betreffende Schicht oder Schichten bildenden Materialien umfasst.

6. Vorrichtung nach einem der Ansprüche 1 bis 5, mit einem Substrat (50), das eine geätzte Stufe (52) aufweist.

7. Vorrichtung nach Anspruch 6, bei der die Höhe (H) der geätzten Stufe (52) gleich der Summe der Dicken der abgeschiedenen Schichten (60) abzüglich der Dicke derjenigen Schichten (62) ist, die die Komponente mit elektronischer Funktion bilden.

8. Vorrichtung nach einem der Ansprüche 1 bis 7, bei der das Substrat (50) vom intrinsisch nicht-absorbierenden Typ ist, um bei der Führung der breiten Mode mitzuwirken.

9. Vorrichtung nach einem der Ansprüche 1 bis 8, bei der der Modenadapter sanduhrförmig geätzt ist.

10. Vorrichtung nach Anspruch 9, bei der der sanduhrförmige Modenadapter einen breitmodigen Eingangsbereich, eine Breitenabnahmezone zum Schieben der Mode in die Tiefe und eine Breitenzunahmezone umfasst, die die Übertragung der breiten Mode zu einem Leiter ermöglicht.

11. Vorrichtung nach einem der Ansprüche 9 oder 10, bei der der sanduhrförmige Modenadapter eine Nut mit nichtverschwindender Breite umfasst.

12. Vorrichtung nach Anspruch 11, bei der die Breite der Nut des sanduhrförmigen Modenadapters in der Größenordnung von 2 µm liegt.

13. Vorrichtung nach einem der Ansprüche 9 bis 12, bei der eine Oberflächenschicht des Modenadapters in dessen Breitenabnahmezone in die Tiefe geätzt ist.

14. Verfahren zur Herstellung einer optoelektronischen Vorrichtung nach einem der Ansprüche 1 bis 13, mit den Schritten, die darin beruhen,
- eine Anordnung von Schichten aus Halbleitermaterial durch Epitaxie auf einem geätzten Substrat (50) abzuscheiden,
- vom oberen Bereich des Substrats die abgeschiedenen Schichten aus Halbleitermaterial zu entfernen, die einer unteren Gruppe (62) überlagert sind, die vorgesehen ist, um eine Komponente mit elektronischer Funktion zu bilden, und
- die im unteren Bereich des Substrats als Modenadapter abgeschiedenen Schichten (60) so zu formen, dass die Schichten (62) aus Halbleitermaterial, die die Komponente mit elektronischer Funktion bilden, gleichzeitig zum Bilden der optischen Schichten in der Modenadapterzone genutzt werden, wobei diese Schichten aus Halbleitermaterial wenigstens im Bereich der Modenadapterzone angepasst sind, um bei der Arbeitswellenlänge der Komponente mit optischer Funktion nicht-absorbierend zu sein.

15. Verfahren nach Anspruch 14, bei dem die Höhe (H) der am Substrat (50) geätzten Stufe gleich oder nahe der Summe der Dicken der durch Epitaxie abgeschiedenen Schichten abzüglich der Dicke der die Komponente mit elektronischer Funktion bildenden Schichten (62) ist.

16. Verfahren nach einem der Ansprüche 14 bis 15, bei dem der Modenadapter durch zonenweises vollständiges Ätzen mit variablen Schritten (66) eines Bandes der Führungsschicht gebildet wird.

17. Verfahren nach einem der Ansprüche 14 bis 16, mit dem Schritt, der darin beruht, einen sanduhrförmigen Modenadapter mit einem breitmodigen Eingangsbereich, einer Breitenabnahmezone zum Schieben der Mode in die Tiefe und einer Breitenzunahmezone, die die Übertragung der breiten Mode zu einem Leiter ermöglicht, zu bilden.

18. Verfahren nach Anspruch 17, bei dem der sanduhrförmige Modenadapter eine Nut mit nicht verschwindender Breite aufweist.

19. Verfahren nach Anspruch 18, bei dem die Breite der Nut des sanduhrförmigen Adapters in der Größenordnung von 2 µm liegt.

20. Verfahren nach einem der Ansprüche 17 bis 19, bei dem der Modenadapter dünne Schichten zum Verdünnen der Mode umfasst.

21. Verfahren nach einem der Ansprüche 17 bis 20, bei dem eine Oberflächenschicht des Modenadapters in der Breitenabnahmezone in die Tiefe geätzt ist.

22. Verfahren nach Anspruch 21, bei dem die Dicke der Oberflächenschicht des Modenadapters in der Größenordnung von 0,2 µm in der Breitenabnahmezone liegt.

23. Verfahren nach einem der Ansprüche 21 oder 22, bei dem die Dicke der Oberflächenschicht des Modenadapters in dessen Breitenzunahmezone in der Größenordnung von 2 µm liegt.

24. Verwendung der Vorrichtung nach einem der Ansprüche 1 bis 13 für die Herstellung einer PIN-HFET-Führungsanordnung.

25. Verwendung einer Vorrichtung nach einem der Ansprüche 1 bis 13 zur Herstellung eines optischen Senders oder eines elektrisch-/optischen Wandlers mit einer integrierten Steuerelektronik.
